(19) Europäisches Patentamt
European Patent Office
Office européen des brevets

(11) **EP 4 361 616 A1**

(12) **EUROPEAN PATENT APPLICATION**

(43) Date of publication:
**01.05.2024 Bulletin 2024/18**

(21) Application number: **22203745.9**

(22) Date of filing: **26.10.2022**

(51) International Patent Classification (IPC):
**G01N 22/02** (2006.01) **A62C 13/00** (2006.01)
**A62C 37/50** (2006.01) **G01R 33/60** (2006.01)

(52) Cooperative Patent Classification (CPC):
**G01N 22/02; G01R 33/60;** A62C 13/00;
A62C 37/50; G01N 22/04

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Universität Bayreuth**
**95447 Bayreuth (DE)**

(72) Inventor: **PETER, Ronny**
**95359 Kasendorf (DE)**

(74) Representative: **Maiwald GmbH**
**Elisenhof**
**Elisenstraße 3**
**80335 München (DE)**

(54) **CONTAINER AND METHOD FOR DETERMINING PROPERTIES OF A CONTAINER**

(57) The invention relates to a method (11) for determining a first property (17) of an electrically conductive inner wall (3) of a container (2), wherein the inner wall (3) confines a cavity (4) of the container (2). A standing electromagnetic wave (13) is excited (12) inside the cavity (4), wherein the cavity (4) acts as a cavity resonator. Then, electromagnetic resonance properties (15) of the cavity (4) are measured (14) and the first property (17) of the electrically conductive inner wall (3) is determined (16), based on the measured (14) electromagnetic resonance properties (15). The invention further relates to a container (2) with an electrically conductive inner wall (3) that confines a cavity (4) of the container (2) and an electromagnetic coupling element (8) and/or means for connecting an electromagnetic coupling element (8).

Fig. 1

**Description**

FIELD OF THE INVENTION

The invention relates to a method for determining a first property of an electrically conductive inner wall of a container and to a respective container.

BACKGROUND OF THE INVENTION

Fire extinguishers should be checked and maintained on a regular basis. For example, German law requires that commercially used fire extinguishers have to be maintained once every two years. This applies both to permanent pressure extinguishers and to rechargeable extinguishers and shall guarantee the correct functioning of the fire extinguishers. Maintenance may comprise checking for damages, checking the pressure and/or checking the condition of the extinguishing agent. For example, for checking the condition of extinguishing powder, the powder is removed from the fire extinguisher, sieved, and then re-filled into the fire extinguisher. Further, the interior of the fire extinguisher may have to be visually inspected. For this, the extinguishing agent first has to be removed and then re-filled after the inspection. The visual inspection itself focuses mostly on corrosion of the inner wall of the fire extinguisher. Alternatives to said visual inspection are penetrant testing and ultrasound testing, which are, however, rarely used.

The above-mentioned maintenance is time consuming and expensive. Further, since the maintenance is based mostly on the experience of the inspector and not on measurements or other quantitative results, it is prone to errors.

SUMMARY OF THE INVENTION

It is therefore an object of the present invention to provide an improved method, in particular a faster and more reliable method, for determining properties of a fire extinguisher or, more generally, of a container with an electrically conductive inner wall. It is a further object of the present invention to provide a related container.

The object of the present invention is solved by the subject matter of the independent claims, wherein further embodiments are incorporated in the dependent claims.

In an aspect of the present invention, a method for determining a first property of an electrically conductive inner wall of a container is provided. Said inner wall confines a cavity of the container. In this context, the cavity may or may not be filled with a filling, and also a partial filling of the cavity is possible. While the entire wall of the container may be electrically conductive, e.g., made out of a metal, the wall of the container may also be made of plastic, with an electrically conductive layer on the inside, such that the inner wall of the container is electrically conductive. Said electrically conductive layer may be a continuous layer or may have a mesh structure.

According to the method, a standing electromagnetic wave is excited inside the cavity by excitation means. Since the inner wall that surrounds the cavity is electrically conductive, the cavity acts as a cavity resonator for said electromagnetic wave.

When the standing electromagnetic wave has been excited, electromagnetic resonance properties of the cavity are measured by measuring means. In particular, the amplitude, and optionally the phase, of the excited wave is measured. The measurement may be performed while the electromagnetic wave is excited, such that the measurement corresponds to a measurement of an electromagnetic reflection coefficient, which may be a complex number. Hence, the electromagnetic resonance properties may comprise the electromagnetic reflection coefficient. Alternatively, or additionally, the electromagnetic resonance properties/the excited electromagnetic wave may be measured after the excitation has been stopped, where an amplitude, a phase and/or a decline rate may be measured. Hence, the electromagnetic resonance properties may comprise an electromagnetic response function including the amplitude, phase and/or decline rate. The amplitude, phase and/or decline rate of the electromagnetic wave depend on the frequency of the electromagnetic wave and on properties of the container and may further depend on the filling(s) of the container and/or on details of an electromagnetic coupling element used to excite and/or to measure the standing electromagnetic wave.

Based on the measured electromagnetic resonance properties, the first property of the electrically conductive inner wall is determined. Hence, this method of determining the first property is minimally invasive and provides a quantifiable and reproducible measurement of the first property. Further, the method is cost-efficient and fast.

According to an embodiment, the container is a pressure container. Since for a pressure container, a visual inspection of the inner wall comprises de-pressurizing the container before the inspection and pressurizing it after the inspection, the method is particularly useful for pressure containers, since the determination of the first property may be performed on the pressurized container.

Alternatively, or additionally, the container is essentially a hollow cylinder. Hence, a computation of the standing electromagnetic waves can be easily performed.

Alternatively, or additionally, the container is a container of a fire extinguisher. By using the method for maintenance, a higher level of safety is provided compared to the standard maintenance methods, in particular the visual inspection, since quantitative measurements are obtained. The maintenance takes less time, since the method may be performed automatically and the container, i.e., the fire extinguisher, does not have to be opened.

According to an embodiment, the first property is a surface defect of the inner wall, in particular corrosion and/or cracks. Since surface defects such as corrosion and cracks change the electric conductivity of the inner wall, they can be determined by the method. Also, corrosion and cracks are among the most severe defects of the inner wall, since they can lead to a destabilized and/or leaky container.

According to an embodiment, the method further comprises determining a second property and/or a third property of a filling contained in the cavity of the container. This determination is, again, based on the measured electromagnetic resonance properties. Hence, also the filling of the container may be inspected. It should be noted that the filling of the container has to be an electric isolator or at least has to have a high electric resistance such that the standing electromagnetic wave can develop inside the cavity.

According to an embodiment, when the container is the container of the fire extinguisher, the filling is an extinguishing agent, preferably an extinguishing powder. In particular, the filling may be a pressurized extinguishing agent or powder.

According to an embodiment, the second property is clumping of the filling contained in the cavity of the container. Said clumping may, in particular, occur when the filling is a powder. Since clumping of the filling may lead to a malfunctioning of the fire extinguisher, determining said second property is also very important.

According to an embodiment, the third property is a moisture of the filling contained in the cavity of the container. Moisture is also a very important property, in particular for an extinguishing agent such as an extinguishing powder, since too much moisture may lead to clumping and hence to malfunctioning of the fire extinguisher. Regarding moisture, the described method has the added benefit that the container does not have to be opened and the filling does not have to be removed for the determination of the properties, such that a potential addition of moisture to the filling during the inspection is avoided.

According to an embodiment, the fourth property is an amount to which the container is filled. In particular, the container may be completely or partially filled, and the amount to which the container is filled may also be determined based on the measured electromagnetic resonance properties. Hence, in addition to a mere measurement of a weight of the container, which may provide an indication of the amount to which the container is filled, a different measurement of the amount to which the container is filled is provided. The results of these two ways of measuring the amount to which the container is filled may be compared to detect potential discrepancies which may point to irregularities of the container.

According to an embodiment, the steps of exciting the standing electromagnetic wave inside the cavity and measuring electromagnetic resonance properties of the cavity are repeated for a plurality of frequencies of the electromagnetic wave. Hence, more data is collected and a more accurate determination of the properties of the inner wall of the container and/or of the properties of the filling may be made. In particular, the frequency of the electromagnetic wave may be swiped over a frequency range, i.e., over said frequency range, an almost continuous frequency response is obtained, yielding a response spectrum.

According to an embodiment, a frequency of the electromagnetic wave is in a range of 100 MHz to 3 GHz. This is the range that is the most sensitive to the first, second, third and/or fourth properties of the electrically conductive inner wall and of the filling, respectively. If the electrically conductive layer has a mesh structure, the loops of the mesh have to be smaller than the wavelength of the electromagnetic wave.

According to an embodiment, the excitation means and measuring means comprise an electromagnetic coupling element. In general, there may be one electromagnetic coupling element for the excitation means and one for the measuring means, however, it is more efficient to have one electromagnetic coupling element for both the excitation means and measuring means. Via said electromagnetic coupling element, the electromagnetic waves are coupled, in particular from a cable, into the cavity and back from the cavity to the cable. The electromagnetic coupling element may be a coupling stub, e.g., a short antenna, a coupling aperture and/or a coupling loop.

The electromagnetic coupling element may be inserted through a filling/emptying valve of the container. Since filling/emptying valves already exist in fire extinguishers, the electromagnetic coupling element can even be used with existing fire extinguishers.

Alternatively, or additionally, the electromagnetic coupling element may be directly arranged through the inner wall of the container. In this case, a good and pressure-proof sealing between the electromagnetic coupling element and the remainder of the inner wall of the container may be provided.

Alternatively, or additionally, the electromagnetic coupling element may be a pressure valve of the container. That is, the pressure valve may be used as the electromagnetic coupling element. Hence, the cables from the excitation means and to the measuring means are to be connected to the pressure valve.

According to an embodiment, the excitation means comprises an electromagnetic signal source. Said electromagnetic signal source is connected to the electromagnetic coupling element, e.g., by a coax cable, by a wave guide or wirelessly.

Alternatively, or additionally, the measuring means comprises an electromagnetic signal receiver. Said electromagnetic signal receiver is also connected to the electromagnetic coupling element, e.g., by a coax cable, by a wave guide or wirelessly.

Alternatively, or additionally, the excitation means and the measuring means comprise a network analyzer. Said network analyzer both provides the electromagnetic excitation signal and performs the measurement of the electromagnetic resonance properties of the cavity. In particular, when a plurality of frequencies is used, or even a swipe over a frequency range, the use of the network analyzer is beneficial, since it includes the synchronization between the excitation means and the measuring means.

The connections between the electromagnetic coupling element and the electromagnetic signal source and/or the receiver by a coax cable or by a wave guide are straightforward. If the electromagnetic coupling element has a wireless connection to the electromagnetic signal source and/or to the receiver, the electromagnetic coupling element has to be connected to an antenna outside of the cavity. Said connection between the electromagnetic coupling element and the antenna may be performed by a waveguide, such as a coax cable, which may further provide impedance matching. Further, a transmitter and a receiver, and/or a transceiver are needed to transmit and/or to receive electromagnetic waves to and from the antenna. With said wireless connection, the preferred method is to first couple the electromagnetic waves into the cavity, then to stop the excitation and then to measure the response. The wireless connection may be used to measure the electromagnetic resonance properties of the cavity from a distance, e.g. from a distance of 10 cm up to a few meters.

According to an embodiment, the determining, based on the measured electromagnetic resonance properties, of the first property, of the second property, of the third property and/or of the fourth property comprises fitting the electromagnetic resonance properties, in particular the amplitudes and phases of the standing electromagnetic waves for an electromagnetic spectral range, to model functions to obtain frequencies and qualities of one or more resonances. Said fitting may be based, in particular, on S-parameters and/or on Z-parameters obtained from the measured electromagnetic resonance properties. The model functions may be analytically calculated functions, based on a simplified model of the cavity, in particular based on a hollow cylinder. The model functions provide the general shape of resonance peaks and may be fit using the parameters frequency and quality. This way, the frequencies and qualities of the resonance are obtained and these quantities may be used to determine the first property, the second property, the third property and/or the fourth property.

According to an embodiment, the determining, based on the measured electromagnetic resonance properties, of the first property, of the second property, of the third property and/or of the fourth property comprises comparing the electromagnetic resonance properties to calculated, modeled and/or measured values. Said comparison may be made using a rule-based approach, may be made by finding the closest distance, based on a measure, of the measured electromagnetic resonance properties from the calculated, modeled and/or measured values, or may be made using a trained artificial intelligence system.

For an analytic calculation, the cavity may be approximated as a hollow right circular cylinder. The resonance frequency of transverse electric modes of such a cavity resonator is

$$f = \frac{c_0}{2\pi\sqrt{\varepsilon_r\mu_r}}\sqrt{\left(\frac{x'_{mn}}{a}\right)^2 + \left(\frac{p\pi}{L}\right)^2}$$

wherein $c_0$ is the speed of light in vacuum, $\varepsilon_r$ is the relative permittivity of the filling, $\mu_r$ is the relative permeability of the filling, $x'_{mn}$ is the n-th zero of the derivative of the m-th Bessel function, p is the mode index in the longitudinal direction, a is the radius of the cylinder and L is the length of the cylinder. Hence, a change in $\varepsilon_r$, e.g., due to clumping and/or moisture, has a direct influence on the resonance frequency. The quality is defined as

$$Q = 2\pi f \frac{W_m + W_e}{P_{loss}}$$

wherein $W_m$ is the magnetic energy in the cavity, $W_e$ is the electric energy in the cavity, and $P_{loss}$ is the general power loss. The general power loss is the sum of power losses due to the filling and power losses from currents in the wall of the cavity, which flow only in a thin layer on the inner wall and are therefore strongly influenced by corroded areas. The power loss due to the wall $P_{wall}$ may be computed as follows:

$$P_{wall} = \frac{R_S}{2}\iiint\limits_{wall}\left|\overrightarrow{H_t}\right|^2 ds$$

wherein $R_S$ is the surface resistance of the inner wall and $H_t$ is the tangential component of the magnetic field. Since the difference in surface resistance of corroded steel to regular steel may be up to 12 orders of magnitude, this has a high influence on the quality.

For modeling of the comparison values, several modeling techniques are known, such as finite element modeling.

Measured values may be obtained from measuring actual containers such as fire extinguishers and thoroughly inspecting them afterwards to determine properties of the inner wall and/or of the filling. The measured electromagnetic resonance properties are then saved together with the results of the thorough inspection.

In another aspect of the invention, a container is provided. In particular, said container is a pressure container and/or a container of a fire extinguisher. The container comprises an electrically conductive inner wall that confines a cavity of the container and an electromagnetic coupling element and/or means for connecting an electromagnetic coupling element. Using said electromagnetic coupling element, the method according to the above description may be performed in order to determine properties of the inner wall and/or of a filling of the cavity. Hence, a minimally invasive measurement can be performed. Further details and advantages are analogous to the above description.

It shall be understood that a preferred embodiment of the invention can also be any combination of the dependent claims with the respective independent claim.

These and other aspects of the invention will be apparent from and elucidated with reference to the embodiments described hereinafter

BRIEF DESCRIPTION OF THE DRAWINGS

In the following, preferred embodiments of the invention will be described, by way of example only, and with reference to the drawings in which:

Fig. 1    shows a schematic cross section through an embodiment of a fire extinguisher;

Fig. 2    shows a flowchart of an embodiment of a method for determining properties of a container; and

Fig. 3    shows a flowchart of another embodiment of a method for determining properties of a container.

In the figures, elements which correspond to elements already described may have the same reference numerals. Examples, embodiments or optional features, whether indicated as nonlimiting or not, are not to be understood as limiting the invention as claimed.

DETAILED DESCRIPTION OF EMBODIMENTS

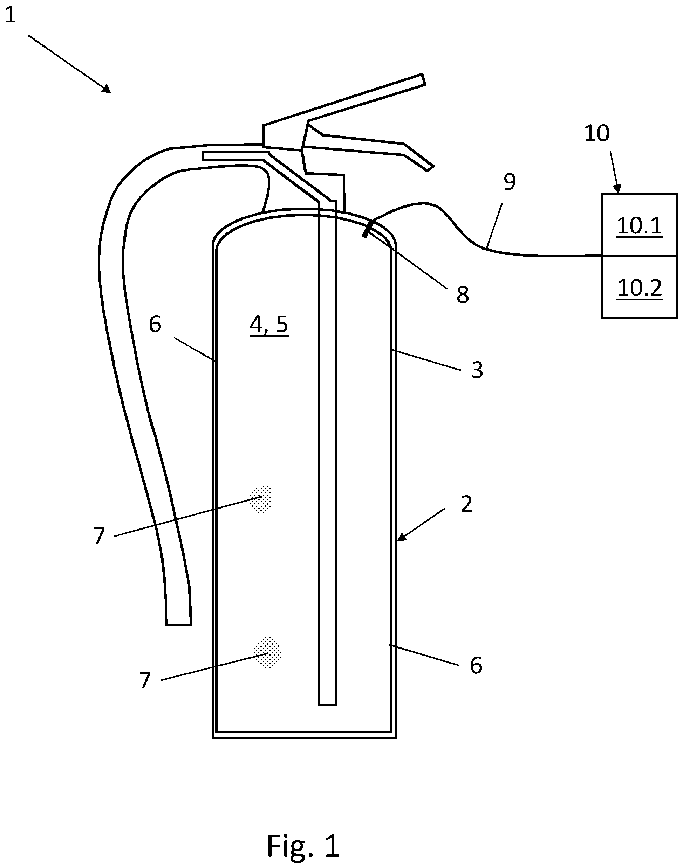

Figure 1 shows a schematic cross section through an embodiment of a fire extinguisher 1. The fire extinguisher 1 comprises a container 2 with an electrically conductive inner wall 3 that confines a cavity 4 of the container 2. The cavity 4 is filled with a filling 5, e.g., with an extinguishing agent, preferably with an extinguishing powder.

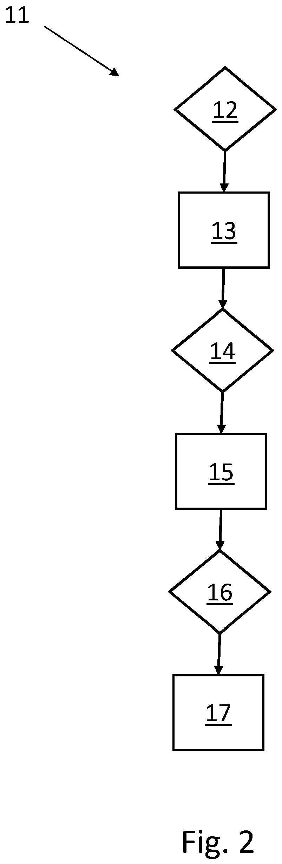

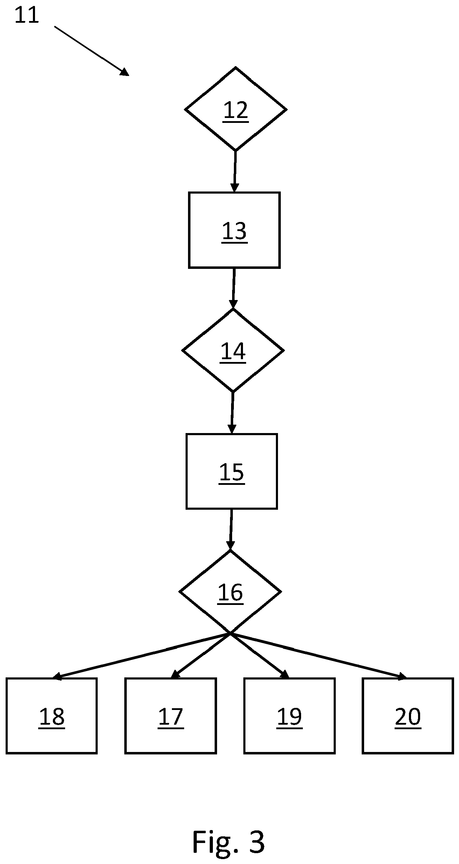

Surface defects 6 of the inner wall 3 are indicated as corroded areas. Also, clumping 7 is shown as a defect of the filling 5. In order to detect these (and other) defects, the methods given in Figures 2 and 3 are proposed.

For said methods, an electromagnetic coupling element 8 is arranged through the inner wall 3 of the container 2. The electromagnetic coupling element 8 is depicted as a coupling stub such as a short antenna, but may also be a coupling aperture and/or a coupling loop. The electromagnetic coupling element 8 is connected via a cable 9 to a network analyzer 10, wherein the network analyzer 10 comprises both an excitation means 10.1 and a measuring means 10.2. As an alternative, the electromagnetic coupling element 8 may be connected to an antenna and the connection to the excitation means 10.1 and/or to the measuring means 10.2 may be performed wirelessly.

Figure 2 shows an embodiment of such a method 11. According to the method 11, a standing electromagnetic wave 13 is excited 12 inside the cavity 4, in particular by the excitation means 10.1.

Then, electromagnetic resonance properties 15 are measured 14 by the measuring means 10.2, using the excited 12 standing electromagnetic wave 13.

Finally, based on the measured 14 electromagnetic resonance properties 15, a first property 17 of the electrically conductive inner wall 3 is determined 16. Said first property 17 is, in particular, a surface defect 6 of the inner wall 3.

Figure 3 shows another embodiment of such a method 11. According to this embodiment, further a second property 18, a third property 19 and/or a fourth property 20 of the filling 5 are determined 16. Here, the second property 18 may relate to clumping 7 of the filling 5 contained in the cavity 4 of the container 2, the third property 19 may relate to a moisture of the filling 5 and the fourth property 20 may relate to an amount to which the container 2 is filled.

Hence, a fast and minimally invasive method 11 for testing a container 2, in particular of a fire extinguisher 1, is provided.

While the invention has been illustrated and described in detail in the drawing and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

Claims

1.  A method (11) for determining a first property (17) of an electrically conductive inner wall (3) of a container (2), wherein the inner wall (3) confines a cavity (4) of the container (2), comprising:

    exciting (12), by excitation means (10.1), a standing electromagnetic wave (13) inside the cavity (4), wherein the cavity (4) acts as a cavity resonator;
measuring (14), by measuring means (10.2), electromagnetic resonance properties (15) of the cavity (4); and
determining (16), based on the measured (14) electromagnetic resonance properties (15), the first property (17) of the electrically conductive inner wall (3).

2. The method (11) according to claim 1, wherein the container (2) is a pressure container, essentially a hollow cylinder and/or a container (2) of a fire extinguisher (1).

3. The method (11) according to claim 1 or 2, wherein the first property (17) is a surface defect (6) of the inner wall (3), in particular corrosion and/or cracks.

4. The method (11) according to any of claims 1 to 3, further comprising: determining (16), based on the measured (14) electromagnetic resonance properties (15), a second property (18), a third property (19) and/or a fourth property (20) of a filling (5) contained in the cavity (4) of the container (2).

5. The method (11) according to claim 4, wherein the filling (5) is an, in particular pressurized, extinguishing agent.

6. The method (11) according to claim 4 or 5, wherein the second property (18) is clumping (7) of the filling (5) contained in the cavity (4) of the container (2).

7. The method (11) according to any of claims 4 to 6, wherein the third property (19) is a moisture of the filling (5) contained in the cavity (4) of the container (2).

8. The method (11) according to any of claims 4 to 7, wherein the fourth property (20) is an amount to which the container (2) is filled.

9. The method (11) according to any of claims 1 to 8, wherein exciting (12) the standing electromagnetic wave (13) inside the cavity (4) and measuring (14) electromagnetic resonance properties (15) of the cavity (4) are repeated for a plurality of frequencies of the electromagnetic wave (13) and is, in particular, swiped over a frequency range.

10. The method (11) according to any of claims 1 to 9, wherein a frequency of the electromagnetic wave (13) is in a range of 100 MHz to 3 Ghz.

11. The method (11) according to any of claims 1 to 10, wherein the excitation means (10.1) and measuring means (10.2) comprise an electromagnetic coupling element (8), wherein the electromagnetic coupling element (8) is, in particular,

   inserted through a filling/emptying valve of the container (2);
   directly arranged through the inner wall (3) of the container (2); and/or
   a pressure valve of the container (2).

12. The method (11) according to any of claims 1 to 11, wherein the excitation means (10.1) comprises an electromagnetic signal source, the measuring means (10.2) comprises an electromagnetic signal receiver and/or the excitation means (10.1) and the measuring means (10.2) comprise a network analyzer (10).

13. The method (11) according to any of claims 1 to 12, wherein the determining (16), based on the measured (14) electromagnetic resonance properties (15), of the first property (17), of the second property (18), of the third property (19) and/or of the fourth property (20) comprises fitting the electromagnetic resonance properties (15) to model functions to obtain frequencies and qualities of one or more resonances.

14. The method (11) according to any of claims 1 to 12, wherein the determining (16), based on the measured (14) electromagnetic resonance properties (15), of the first property (17), of the second property (18), of the third property (19) and/or of the fourth property (20) comprises comparing the electromagnetic resonance properties (15) to calculated, modeled and/or measured values.

15. A container (2), particularly a pressure container and/or a container (2) of a fire extinguisher (1), comprising

   an electrically conductive inner wall (3) that confines a cavity (4) of the container (2); and
   an electromagnetic coupling element (8) and/or means for connecting an electromagnetic coupling element (8).

Fig. 1

11

Fig. 2

11

12

13

14

15

16

18   17   19   20

Fig. 3

Europäisches
Patentamt

European
Patent Office

Office européen
des brevets

# EUROPEAN SEARCH REPORT

Application Number

EP 22 20 3745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/097561 A1 (DESMULLIEZ MARC [GB] ET AL) 9 April 2015 (2015-04-09) * paragraph [0034] – paragraph [0039]; figures 1, 12-15, 17 * * paragraph [0044] – paragraph [0066] * | 1-15 | INV. G01N22/02 A62C13/00 A62C37/50 G01R33/60 |
| X | US 9 310 321 B1 (JOHNSON MARK [US] ET AL) 12 April 2016 (2016-04-12) | 1-3,9-15 | |
| A | * column 4, line 38 – column 5, line 31; figure 1 * | 4-8 | |

TECHNICAL FIELDS
SEARCHED (IPC)

G01N
A62C
G01R

The present search report has been drawn up for all claims

| Place of search | Date of completion of the search | Examiner |
|---|---|---|
| The Hague | 2 March 2023 | Stavroulakis, E |

EPO FORM 1503 03.82 (P04C01)

Europäisches
Patentamt

European
Patent Office

Office européen
des brevets

Application Number

EP 22 20 3745

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

**1. claims: 1-15**

    Measuring electromagnetic resonance properties in a container.

**1.1. claims: 1, 2, 9-12, 15(completely); 13, 14(partially)**

    Determining a property under pressurised conditions.

**1.2. claim: 3**

    Determining the integrity of the inner wall.

**1.3. claims: 4-8(completely); 13, 14(partially)**

    Characterising the filling.

---

Please note that all inventions mentioned under item 1, although not necessarily linked by a common inventive concept, could be searched without effort justifying an additional fee.

**ANNEX TO THE EUROPEAN SEARCH REPORT**
**ON EUROPEAN PATENT APPLICATION NO.**

EP 22 20 3745

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2023

| Patent document cited in search report | | Publication date | Patent family member(s) | | Publication date |
|---|---|---|---|---|---|
| US 2015097561 | A1 | 09-04-2015 | AU | 2013255647 A1 | 27-11-2014 |
| | | | BR | 112014027286 A2 | 27-06-2017 |
| | | | CA | 2871984 A1 | 07-11-2013 |
| | | | CN | 104704351 A | 10-06-2015 |
| | | | EP | 2844986 A1 | 11-03-2015 |
| | | | JP | 6196664 B2 | 13-09-2017 |
| | | | JP | 2015517651 A | 22-06-2015 |
| | | | US | 2015097561 A1 | 09-04-2015 |
| | | | WO | 2013164627 A1 | 07-11-2013 |
| US 9310321 | B1 | 12-04-2016 | NONE | | |

EPO FORM P0459

For more details about this annex : see Official Journal of the European Patent Office, No. 12/82